# EUROPEAN PATENT APPLICATION

(11) **EP 4 579 738 A1**
(43) Date of publication of application: **02.07.2025**
(21) Application number: 24215565.3
(22) Date of filing: 26.11.2024
(51) Int. Cl.: H01L 23/498, H01L 23/538

(54) **ELECTRONIC DEVICE PACKAGE WITH KELVIN CONTACTING**

(30) Priority: 15.12.2023 US 202363611018 P; 15.08.2024 US 202418806517
(71) Applicant: Analog Devices International Unlimited Company, Limerick (IE)
(72) Inventor: Aherne, David, Limerick (IE); Nolan, Derek, Limerick (IE); Burke, Cillian, Limerick (IE); Santillan, Jofrey Generalao, Limerick (IE); Maccorkle, Michael, Limerick (IE)
(74) Representative: Horler, Philip John

(57) **Abstract**

Aspects of the disclosure relate to an electronic device package. The electronic device package can include a laminate substrate. The electronic device package can include connection pads disposed on the laminate substrate and along a perimeter of the electronic device package. Connection pads that are along a first side of the laminate substrate can have a first orientation that is different than a second orientation of connection pads that are along a second side of the laminate substrate. The first side can be adjacent to the second side. Each of connection pads can have a minimum size for Kelvin sensing in a process technology for manufacturing the electronic device package. The electronic device package can include a die enclosed within a packaging structure.

## Description

### CROSS REFERENCE TO RELATED APPLICATION

This application claims the benefit of priority of U.S. Application No. 18/806,517, filed August 15, 2024 and tilted "LAND GRID ARRAY PACKAGE WITH KELVIN CONTACTING" and U.S. Provisional Application No. 63/611,018, filed December 15, 2023 and titled "LAND GRID ARRAY PACKAGE WITH KELVIN CONTACTING," the disclosures of which are hereby incorporated by reference in their entireties and for all purposes.

### BACKGROUND

### TECHNICAL FIELD

Embodiments of this disclosure relate to electronic device packaging.

### DESCRIPTION OF RELATED TECHNOLOGY

Electronic device packaging can provide structural and thermal support for electronic devices, such as integrated circuits. Electronic device packaging can also provide electrical connections, such as input and output connections ("I/O connections") and electrical isolation for the electronic devices.

### SUMMARY OF CERTAIN INVENTIVE ASPECTS

The innovations described in the claims each have several aspects, no single one of which is solely responsible for its desirable attributes. Without limiting the scope of the claims, some prominent features of this disclosure will now be briefly described.

One aspect of this disclosure is an electronic device package. The electronic device package includes a laminate substrate. The electronic device package includes a plurality of connection pads disposed on the laminate substrate and along a perimeter of the electronic device package. First connection pads of the plurality of connection pads that are along a first side of the laminate substrate have a first orientation that is different than a second orientation of second connection pads of the plurality of connection pads that are along a second side of the laminate substrate. The first side is adjacent to the second side. Each of the plurality of connection pads is a minimum size for Kelvin sensing in a process technology for manufacturing the electronic device package. The electronic device package includes a die enclosed within a packaging structure.

The electronic device package can further include an exposed paddle disposed centrally on a same side of the laminate substrate as the plurality of connection pads.

A corner of the exposed paddle can include an orientation feature indicating a position of a particular pin.

The plurality of connection pads can include 16 connection pads. The electronic device package can have a footprint of 2 millimeters by 2 millimeters.

A different numbers of connection pads of the plurality of connection pads can be positioned along the first side than the second side.

Each of the connection pads can be spaced apart from an adjacent connection pad by a minimum spacing of a process technology for manufacturing the electronic device package.

Each of the connection pads can have dimensions of 260 micrometers (µm) +/- 26 µm by 170 µm +/- 17 µm.

The die can include an analog switch.

The electronic device package can include a second die and signal routing in the laminate substrate that provides one or more electrical connections between the die and the second die.

The electronic device package can include signal routing in the laminate substrate that provides an electrical connection between the die and a connection pad of the plurality of connection pads.

Each of the connection pads can be rectangular.

The electronic device package can be a land grid array package.

One or more of the connection pads can provide input/output connections to the die.

A central area of the electronic device package can be free from the plurality of connection pads.

A connection pad of the plurality of connection pads can be spaced apart from an edge of the laminate substrate by a distance in a range from 70 µm to 80 µm.

Two adjacent connection pads of the plurality of connection pads can have a pitch distance in a range from 380 µm to 420 µm.

Another aspect of this disclosure is an electronic device package. The electronic device package includes a plurality of connection pads disposed on a substrate. The plurality of connection pads includes 16 connection pads positioned around a periphery of the substrate. Each of the plurality of connection pads are dimensioned for Kelvin contacting. The electronic device package includes a die enclosed within a packaging structure. The electronic device package has a footprint of 2 millimeters by 2 millimeters.

Each of the connection pads can have dimensions of 260 µm +/- 10% by 170 µm +/- 10%.

The electronic device package can include an exposed die paddle positioned on the substrate on a same side as the plurality of connection pads. The exposed die paddle can be surrounded by the plurality of connection pads.

Another aspect of this disclosure is an electronic device package. The electronic device package includes a laminate substrate including one or more signal routing layers. The electronic device package includes a plurality of connection pads disposed on the laminate substrate. The plurality of connection pads include 16 connection pads positioned around a periphery of the laminate substrate. Each of the plurality of connection pads has a rectangular footprint with dimensions of 260 µm +/- 10% by 170 µm +/- 10%. The electronic device package includes a die enclosed within a packaging structure. The die is electrically connected to connection pads of the plurality of connection pads by way of the one or more signal routing layers. The electronic device package has a footprint of 2 millimeters by 2 millimeters.

### BRIEF DESCRIPTION OF THE DRAWINGS

Embodiments of this disclosure will be described, by way of non-limiting example, with reference to the accompanying drawings.
Figure 1A is a schematic diagram of a top view of an electronic device package according to an embodiment.
Figure 1B is a schematic diagram of a bottom view of an electronic device package according to an embodiment.
Figure 1C is a schematic diagram of a side view of an electronic device package according to an embodiment.
Figure 1D is a a schematic diagram of a bottom view of an electronic device package according to another embodiment.
Figure 1E is a a schematic diagram of a bottom view of an electronic device package according to another embodiment.
Figure 2 is a schematic diagram of an electronic device package with a metal layer and a solder mask layer shown according to another embodiment.
Figure 3A is a schematic diagram of an electronic device package with a metal layer shown according to another embodiment.
Figure 3B is a schematic diagram of an electronic device package with a metal layer and a solder mask layer shown according to another embodiment.
Figure 3C is a schematic diagram of an electronic device package with a final package outline shown according to another embodiment.
Figure 4 illustrates a Kelvin connector according to an embodiment.

### DETAILED DESCRIPTION OF CERTAIN EMBODIMENTS

The following detailed description of certain embodiments presents various descriptions of specific embodiments. However, the innovations described herein can be embodied in a multitude of different ways, for example, as defined and covered by the embodiments. In this description, reference is made to the drawings where like reference numerals can indicate identical or functionally similar elements. It will be understood that elements illustrated in the figures are not necessarily drawn to scale. Moreover, it will be understood that certain embodiments can include more elements than illustrated in a drawing and/or a subset of the illustrated elements. Further, some embodiments can incorporate any suitable combination of features from two or more drawings.

Aspects of this disclosure relate to an electronic device package with connection pads dimensioned for Kelvin contacting. The connection pads can be formed on a laminate substrate. Kelvin contacting connections can greatly reduce or eliminate the impact of contact resistance at the connections. Kelvin contacting may be useful in a variety of applications. For example, Kelvin contacting may be useful in precise measurement of resistances, such as for low resistance components, and in precise measurements of voltage, as well as in other circumstances.

Kelvin contacting may utilize multiple pin connections on the same connection pad. The size of connection pads may be constrained to accommodate the multiple pin connections. Reducing the overall size of an electronic device package that utilizes connections pads dimensioned for Kelvin contacting may be difficult due to such size constraints.

Embodiments of this disclosure relate to an electronic device package with a geometric arrangement of features that allow for a reduction in the overall footprint of the electronic device package while maintaining connection pads dimensioned for Kelvin contacting. The electronic device packaging disclosed herein can have several advantages. Kelvin contacting may eliminate or greatly reduce the impact of contact resistance from supply rails, from ground referenced measurements, and/or from low impedance resistance paths. The electronic device packaging disclosed herein may enable accurate Rₒₙ and Rₒₙ matching measurements, enable a simplified and robust manufacturing flow by eliminating the need of costly Kelvin probing, minimizing yield impacting guard bands for certain performance specifications, reduce the sensitivity of production test setups to contact resistance, or any combination thereof. Advantageously, the foregoing examples may be accomplished while reducing the overall footprint of the electronic device package.

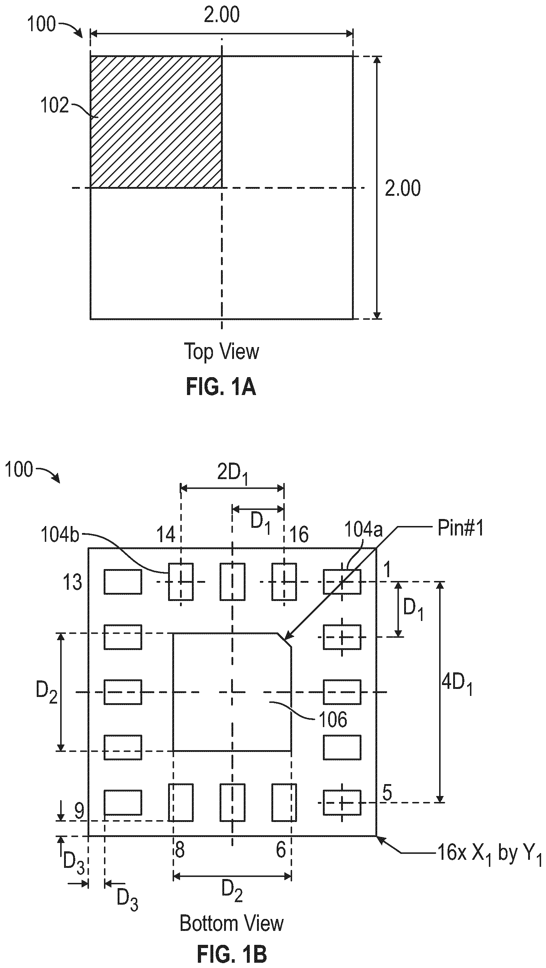

Figures 1A-1C illustrate an electronic device package 100 according to an embodiment. The electronic device package 100 may utilize various electronic packaging technologies. For example, the electronic device package 100 may utilize a land grid array ("LGA") package or other packaging technologies. LGA packages are laminate substrate-based packages that include metal pads for external electrical connections. While various dimensions are described with respect to electronic device package 100, other suitable dimensions may be utilized in the electronic device package 100. The electronic device package 100 can include a die. The die can include an analog switch. Using Kevlin contacts to measure parameters of an analog switch can be particularly useful. The die can alternatively or additionally include any other suitable circuitry.

Figure 1A illustrates a top view of the electronic device package 100 (also referred to herein as a semiconductor device package). As illustrated in Figure 1A, the electronic device package 100 may have a 2 mm by 2 mm footprint, for example. Figure 1A illustrates an index area 102 over a pin 1 corner of the electronic device package 100.

Figure 1B illustrates a bottom view of the electronic device package 100. As illustrated in Figure 1B, the electronic device package 100 may include sixteen connection pads 104 disposed along the outer edges of the electronic device package 100 and a paddle 106 disposed on the center of the electronic device package 100. The sixteen connection pads 104 can provide unique input/outputs for the electronic device package 100. Individual connection pads 104a and 104b of the connection pads 104 are labeled in Figure 1B. The arrangement of the connection pads 104 is provided as an example and other arrangements may be used. For instance, Figure 1B illustrates sixteen connection pads arranged in a 3-5-3-5 pin arrangement, beginning at connection pad 104a corresponding to pin 1. However, other arrangements of the connection pads 104 may be utilized. For example, a 5-3-5-3 pin arrangement may be used, more than sixteen connection pads 104 may be used, fewer than sixteen connection pads 104 may be used (e.g., a 4-3-4-3 pin arrangement, a 3-4-3-4 pin arrangement, etc.), and/or other arrangements of the connection pads 104 may be utilized.

Each of the connection pads 104 are rectangular in Figure 1B. Each connection pad 104 can be dimensioned for Kevlin contacting. For instance, each connection pad 104 can have a minimum area for Kelvin contacting in a process technology for manufacturing the electronic device package 100. The connection pads 104 are on a laminate substrate. The laminate substrate can provide mechanical support for a die. There can be one or more signal routing layers in the laminate substrate to electrically connect dies of the electronic device package 100 to each other and/or to electrically connect a die of the electronic device package 100 to one or more connection pads 104. The connection pads 104 are inline input/outputs in the electronic device 100. In some embodiments, because each of the connection pads 104 is capable of Kelvin contacting, any of the connection pads 104 can be defined and/or redefined to perform desired functions, increasing the flexibility of the electronic device package 100.

In some implementations, the connection pads 104 may be arranged in two orthogonal orientations in the same plane on a surface of the electronic device package 100. For example, Figure 1B illustrates two groups of five connection pads 104 arranged in a first orientation (e.g., as illustrated by connection pad 104a) and two groups of three connection pads 104 arranged on a second orientation (e.g., as illustrated by connection pad 104b) on the same plane but orthogon to the first orientation. The two groups of five connection pads 104 are positioned along opposing sides of the semiconductor device package 100. The two groups of three connection pads 104 are positioned along other opposing sides of the semiconductor device package 100.

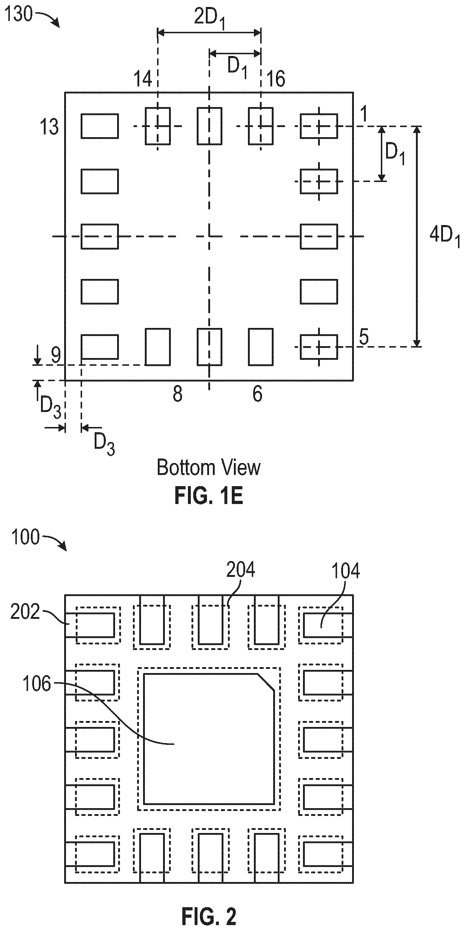

In Figure 1B the semiconductor device package 100 includes an exposed paddle 106. In some other implementations, a similar electronic device package may not include a paddle 106, for example, as illustrated in Figure 1E. The paddle 106 is illustrated as including an orientation feature in a corner indicating the position of the connection pad 104a that corresponds to pin 1. In Figure 1B, the orientation feature is a notch or a chamfer. In some other implementations, the paddle 106 may include another orientation feature or not include an orientation feature. The paddle 106 may help thermal dissipation of the electronic device package 100.

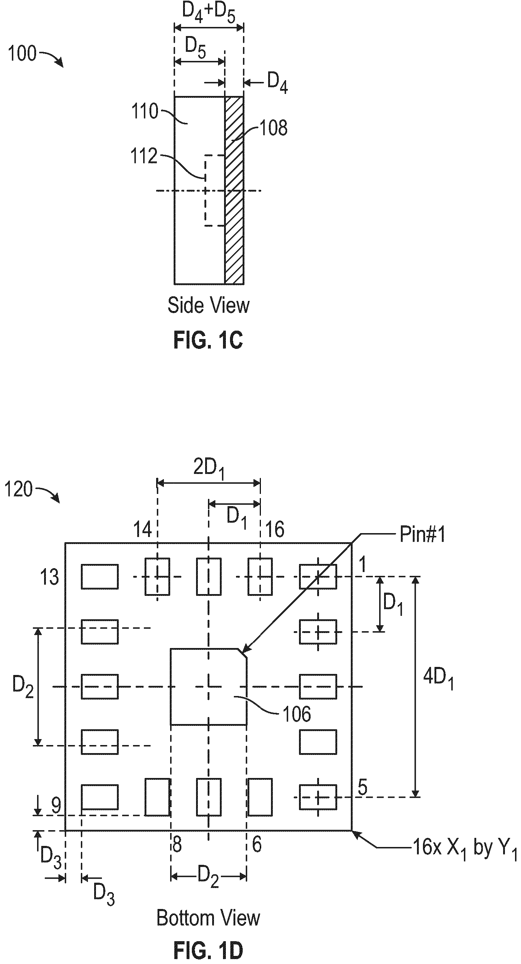

Each connection pad 104 may have dimensions indicated by X₁ by Y₁. X₁ and Yi may be dimensioned for Kelvin contacting. For example, X₁ may be approximately 260 µm and Y₁ may be approximately 170 µm. In some implementations, X₁ and Y₁ may have tolerances of approximately 50 µm. In certain applications, X₁ can be 260 µm +/- 10% and Yi can be 170 µm +/- 10%. In some such applications, X₁ can be 260 µm +/- 5% and Y₁ can be 170 µm +/- 5%. Each connection pad 104 may have a pitch distance (the center to center distance from adjacent, similarly oriented connection pads 104) of D₁. In some embodiments, D₁ is approximately 400 µm. For example, D₁ can be in a range from 380 µm to 420 µm. In certain applications, D₁ can be in a range from 300 µm to 500 µm. Each connection pad 104 with a side adjacent to an edge may have a distance of D₃ to an edge the connection pad 104 is oriented along. In some embodiments, D₃ may be approximately 75 µm. In certain applications, D₃ can be in a range from 70 µm to 95 µm, such as in a range from 70 µm to 80 µm. For example, connection pad 104a may be approximately 75 µm from the right edge illustrated in Figure 1B and connection pad 104b may be approximately 75 µm from the top edge illustrated in Figure 1B. The paddle 106 may have sides of a length indicated by D₂. In some embodiments D₂ may be approximately 920 µm. In some embodiments, the paddle 106 may be smaller than illustrated in Figure 1B, for example, as illustrated in Figure 1D. As such, D₂ may have a reduced length, such as approximately 570 µm, in some embodiments. In some embodiments, no paddle may be present on a semiconductor device package, for example, as illustrated in Figure 1E.

Figure 1C illustrates a side view of the electronic device package 100 with a first layer 108 and a second layer 110. The first layer 108 may comprise a laminate substrate with a thickness of D₄. In some embodiments, D₄ may be approximately 205 µm thick. In various implementations, the first layer 108 may have an approximately 40 µm tolerance. The connection pads 104 and the paddle 106 may be formed on the first layer 108. The second layer 110 may comprise a mold compound that encapsulates a die 112. The relative size of the die 112, as illustrated in Figure 1C is provided as an example. In some embodiments, the die 112 may be smaller or larger than is illustrated in Figure 1C. The second layer 110 may have a thickness of D₅.

Figure 1D is a a schematic diagram of a bottom view of an electronic device package 120 according to another embodiment. The electronic device package 120 is like the electronic device package 100 of Figures 1A to 1C, except that the electronic device package 120 includes a smaller die paddle 106 than the electronic device package 100.

Figure 1E is a a schematic diagram of a bottom view of an electronic device package 130 according to another embodiment. The electronic device package 130 is like the electronic device package 100 of Figures 1A to 1C, except that the electronic device package 130 does not include a die paddle 106.

Figure 2 illustrates another embodiment of an electronic device package 100 with a metal layer 204 and a solder mask layer 202 shown. In various implementations, the solder mask layer 202 may be applied over the metal layer 204. The connection pads 104 and paddle 106 can be accessed through the solder mask layer 202.

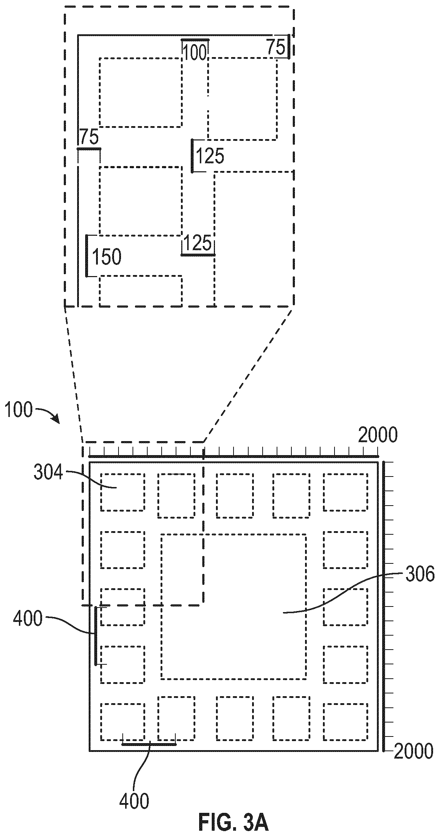

Figures 3A-3C illustrate an embodiment of an electronic device package 100. Figure 3A illustrates the electronic device package 100 with only the metal layer, such as the metal layer 204 of Figure 2, shown. As illustrated in Figure 3A, the metal layer can include traces 304 that correspond to the connection pads 104 and a center trace 306 that corresponds to the paddle 106. The traces 304 may have a distance of approximately 75 µm between the traces 304 and an edge. The traces 304 may have a center to center distance of approximately 400 µm. The traces 304 may have a gap between traces of approximately 100 µm. In various implementations, the gap between traces 304 may vary depending on the orientation of the traces 304. For example, adjacent traces 304 of the same orientation may have a gap of approximately 150 µm while the gap between a trace 304 of one orientation that is adjacent to a trace 304 of another orientation may be approximately 100 µm. In various implementations, the gap between the traces 304 and the center trace 306 may be approximately 125 µm. In other implementations, the gap between the traces 304 and the center trace 306 may be approximately 100 µm. The above listed dimensions, and the dimensions illustrated in Figure 3A, are given for illustrative purposes only and other dimensions may be used.

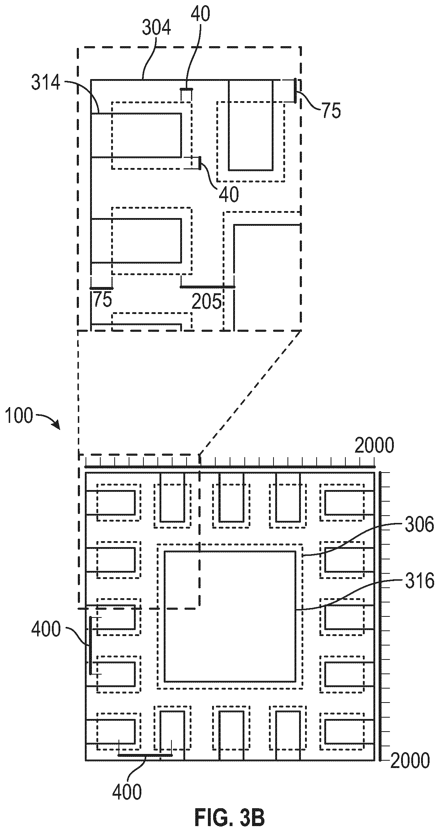

Figure 3B illustrates the electronic device package 100 with a metal layer, such as the metal layer 204 of Figure 2, and a solder mask layer, such as the solder mask layer 202 of Figure 2, shown. As illustrated in Figure 3B, the solder mask layer can include connection pad solder masks 314 and paddle solder masks 316. The each of the connection pad solder masks 314 may cover a portion of a trace 304 to form a connection pad. Similarly, the paddle solder masks 316 may cover a portion of the center trace 306 to form a paddle. In various implementations, the distance between the edge of a trace 304 and a corresponding connection pad solder mask 314 may be approximately 40 µm. In other implementations, the distance between the edge of a trace 304 and a corresponding connection pad solder mask 314 may be approximately 50 µm. In various implementations, the distance between the paddle solder masks 316 and an adjacent connection pad solder mask 314 may be approximately 205 µm. In other implementations, the distance between the paddle solder masks 316 and an adjacent connection pad solder mask 314 may be approximately 200 µm. The center to center distance of adjacent connection pad solder masks 314 may be approximately 400 µm. The above listed dimensions, and the dimensions illustrated in Figure 3B, are given for illustrative purposes only and other dimensions may be used.

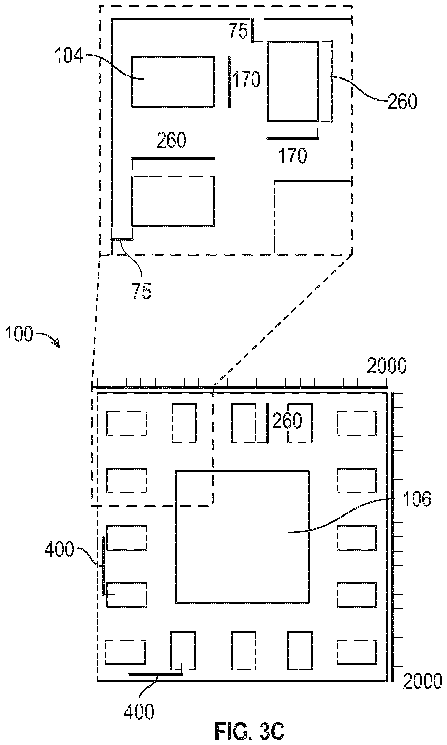

Figure 3C illustrates the electronic device package 100 with the final package outline shown. As illustrated in Figure 3C, the final package outline can include connection pads 104 and paddle 106. The connection pads 104 may have approximate dimensions of 170 µm by 260 µm. The electronic device package 100 may have a pitch dimension of approximately 400 µm. Each paddle 106 may have a distance of approximately 75 µm to the closest edge. Figure 3C illustrates paddle 106 without a notch indicating pin 1. However, as illustrated in Figure 1B, paddle 106 may have a notched corner indicating pin 1. The above listed dimensions, and the dimensions illustrated in Figure 3C, are given for illustrative purposes only and other dimensions may be used.

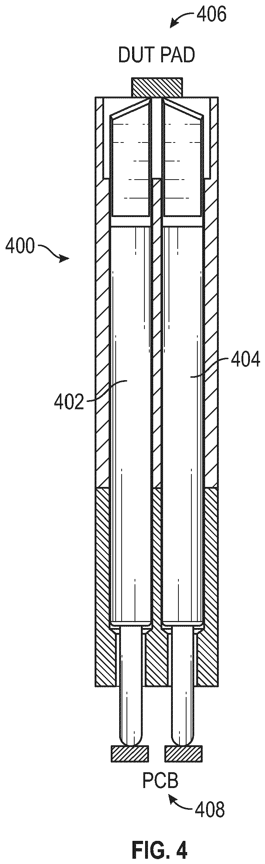

Figure 4 illustrates a Kelvin connector 400 according to an embodiment. As illustrated in Figure 4, the Kelvin connector 400 can include a first pin 402 and a second pin 404. The first pin 402 and the second pin 404 may be connected to the same pad on a first end 406. The pad on the first end 406 may correspond to a pad on the device under test ("DUT"). In various embodiments, the first pin 402 and the second pin 404 may have a shorted electrical connection at the first end 406. The first pin 402 and the second pin 404 may be connected to separate connections at a second end 408. For example, the first pin 402 and the second pin 404 may be connected to separate terminals of a printed circuit board ("PCB). In various implementations, the Kelvin connector 400 may be utilized with the electronic device package 100. For example, a Kelvin connector 400 may be used to connect to a connection pad 104.

Unless the context clearly requires otherwise, throughout the description and the embodiments, the words "comprise," "comprising," "include," "including," and the like are to be construed in an inclusive sense, as opposed to an exclusive or exhaustive sense; that is to say, in the sense of "including, but not limited to." Additionally, the words "herein," "above," "below," and words of similar import, when used in this application, shall refer to this application as a whole and not to any particular portions of this application. Where the context permits, words in the Detailed Description using the singular or plural number may also include the plural or singular number, respectively. The words "or" in reference to a list of two or more items, is intended to cover all of the following interpretations of the word: any of the items in the list, all of the items in the list, and any combination of the items in the list. All numerical values provided herein are intended to include similar values within a measurement error.

Moreover, conditional language used herein, such as, among others, "can," "could," "might," "may," "e.g.," "for example," "such as" and the like, unless specifically stated otherwise, or otherwise understood within the context as used, is generally intended to convey that certain embodiments include, while other embodiments do not include, certain features, elements and/or states.

The teachings provided herein can be applied to other systems, not necessarily the systems described above. The elements and acts of the various embodiments described above can be combined to provide further embodiments. The acts of the methods discussed herein can be performed in any order as appropriate. Moreover, the acts of the methods discussed herein can be performed serially or in parallel, as appropriate.

While certain embodiments have been described, these embodiments have been presented by way of example only, and are not intended to limit the scope of the disclosure. Indeed, the novel methods and systems described herein may be embodied in a variety of other forms. Furthermore, various omissions, substitutions and changes in the form of the methods and systems described herein may be made without departing from the spirit of the disclosure. For example, while the disclosed embodiments are presented in given arrangements, alternative embodiments may perform similar functionalities with different components and/or circuit topologies, and some elements may be deleted, moved, added, subdivided, combined, and/or modified. Each of these elements may be implemented in a variety of different ways as suitable. Any suitable combination of the elements and acts of the various embodiments described above can be combined to provide further embodiments. The accompanying claims and their equivalents are intended to cover such forms or modifications as would fall within the scope and spirit of the disclosure. Accordingly, the scope of the present inventions is defined by reference to the claims.

### ASPECTS OF THE DISCLOSURE

Non-limiting aspects of the disclosure are set out in the following numbered clauses.
1. An electronic device package comprising:
   a laminate substrate;
   a plurality of connection pads disposed on the laminate substrate and along a perimeter of the electronic device package, first connection pads of the plurality of connection pads that are along a first side of the laminate substrate having a first orientation that is different than a second orientation of second connection pads of the plurality of connection pads that are along a second side of the laminate substrate, the first side being adjacent to the second side, and each of the plurality of connection pads is a minimum size for Kelvin sensing in a process technology for manufacturing the electronic device package; and
   a die enclosed within a packaging structure.
2. The electronic device package of Clause 1, further comprising an exposed paddle disposed centrally on a same side of the laminate substrate as the plurality of connection pads.
3. The electronic device package of Clause 2, wherein a corner of the exposed paddle comprises an orientation feature indicating a position of a particular pin.
4. The electronic device package of any preceding Clause, wherein the plurality of connection pads comprises 16 connection pads, and the electronic device package has a footprint of 2 millimeters by 2 millimeters.
5. The electronic device package of any preceding Clause, wherein a different numbers of connection pads of the plurality of connection pads are positioned along the first side than the second side.
6. The electronic device package of any preceding Clause, wherein each of the connection pads is spaced apart from an adjacent connection pad by a minimum spacing of a process technology for manufacturing the electronic device package.
7. The electronic device package of any preceding Clause, wherein each of the connection pads has dimensions of 260 micrometers (µm) +/- 26 µm by 170 µm +/- 17 µm.
8. The electronic device package of any preceding Clause, wherein the die comprises an analog switch.
9. The electronic device package of any preceding Clause, further comprising a second die and signal routing in the laminate substrate that provides one or more electrical connections between the die and the second die.
10. The electronic device package of any preceding Clause, further comprising signal routing in the laminate substrate that provides an electrical connection between the die and a connection pad of the plurality of connection pads.
11. The electronic device package of any preceding Clause, wherein each of the connection pads is rectangular.
12. The electronic device package of any preceding Clause, wherein the electronic device package is a land grid array package.
13. The electronic device package of any preceding Clause, wherein one or more of the connection pads provide input/output connections to the die.
14. The electronic device package of any preceding Clause, wherein a central area of the electronic device package is free from the plurality of connection pads.
15. The electronic device package of any preceding Clause, wherein a connection pad of the plurality of connection pads is spaced apart from an edge of the laminate substrate by a distance in a range from 70 µm to 95 µm.
16. The electronic device package of any preceding Clause, wherein two adjacent connection pads of the plurality of connection pads have a pitch distance in a range from 380 µm to 420 µm.
17. An electronic device package comprising:
   a plurality of connection pads disposed on a substrate, the plurality of connection pads comprising 16 connection pads positioned around a periphery of the substrate, and each of the plurality of connection pads dimensioned for Kelvin contacting; and
   a die enclosed within a packaging structure, wherein the electronic device package has a footprint of 2 millimeters by 2 millimeters.
18. The electronic device package of Clause 17, wherein each of the connection pads has dimensions of 260 µm +/- 10% by 170 µm +/- 10%.
19. The electronic device package of Clause 17 or Clause 18, further comprising an exposed die paddle positioned on the substrate on a same side as the plurality of connection pads, the exposed die paddle being surrounded by the plurality of connection pads.
20. An electronic device package comprising:
   a laminate substrate comprising one or more signal routing layers;
   a plurality of connection pads disposed on the laminate substrate, the plurality of connection pads comprising 16 connection pads positioned around a periphery of the laminate substrate, and each of the plurality of connection pads having rectangular footprint with dimensions of 260 µm +/- 10% by 170 µm +/- 10%; and
   a die enclosed within a packaging structure, the die electrically connected to connection pads of the plurality of connection pads by way of the one or more signal routing layers, wherein the electronic device package has a footprint of 2 millimeters by 2 millimeters.

## Claims

1. An electronic device package comprising:
a laminate substrate;
a plurality of connection pads disposed on the laminate substrate and along a perimeter of the electronic device package, first connection pads of the plurality of connection pads that are along a first side of the laminate substrate having a first orientation that is different than a second orientation of second connection pads of the plurality of connection pads that are along a second side of the laminate substrate, the first side being adjacent to the second side, and each of the plurality of connection pads is a minimum size for Kelvin sensing in a process technology for manufacturing the electronic device package; and
a die enclosed within a packaging structure.

2. The electronic device package of Claim 1, further comprising an exposed paddle disposed centrally on a same side of the laminate substrate as the plurality of connection pads.

3. The electronic device package of Claim 2, wherein a corner of the exposed paddle comprises an orientation feature indicating a position of a particular pin.

4. The electronic device package of any preceding Claim, wherein the plurality of connection pads comprises 16 connection pads, and the electronic device package has a footprint of 2 millimeters by 2 millimeters.

5. The electronic device package of any preceding Claim, wherein a different numbers of connection pads of the plurality of connection pads are positioned along the first side than the second side.

6. The electronic device package of any preceding Claim, wherein each of the connection pads is spaced apart from an adjacent connection pad by a minimum spacing of a process technology for manufacturing the electronic device package.

7. The electronic device package of any preceding Claim, wherein each of the connection pads has dimensions of 260 micrometers (µm) +/- 26 µm by 170 µm +/- 17 µm.

8. The electronic device package of any preceding Claim, wherein the die comprises an analog switch.

9. The electronic device package of any preceding Claim, further comprising a second die and signal routing in the laminate substrate that provides one or more electrical connections between the die and the second die.

10. The electronic device package of any preceding Claim, further comprising signal routing in the laminate substrate that provides an electrical connection between the die and a connection pad of the plurality of connection pads.

11. The electronic device package of any preceding Claim, wherein each of the connection pads is rectangular.

12. The electronic device package of any preceding Claim, wherein the electronic device package is a land grid array package.

13. The electronic device package of any preceding Claim, wherein one or more of the connection pads provide input/output connections to the die.

14. The electronic device package of any preceding Claim, wherein a central area of the electronic device package is free from the plurality of connection pads.

15. The electronic device package of any preceding Claim, wherein at least one of the following applies:
(a) a connection pad of the plurality of connection pads is spaced apart from an edge of the laminate substrate by a distance in a range from 70 µm to 95 µm
(b) two adjacent connection pads of the plurality of connection pads have a pitch distance in a range from 380 µm to 420 µm.
